# DEMANDE DE BREVET EUROPEEN

(11) **EP 2 605 067 A2**
(43) Date de publication de la demande: **19.06.2013**
(21) Numéro de dépôt: 12196598.2
(22) Date de dépôt: 11.12.2012
(51) Int. Cl.: G03F 7/00

(54) **Moule de lithographie par nanoimpression**

(30) Priorité: 12.12.2011 FR 1161464
(71) Demandeur: COMMISSARIAT A L'ENERGIE ATOMIQUE ET AUX ENERGIES ALTERNATIVES, 75015 Paris (FR)
(72) Inventeur: Landis, Stéphan, 38500 VOIRON (FR); Hyot, Bérangère, 38320 EYBENS (FR)
(74) Mandataire: Hautier, Nicolas

(57) **Abrégé**

La présente invention porte sur un procédé de fabrication d'un moule de lithographie par nanoimpression. Le procédé comprend une étape initiale de dépôt sur un support mécanique d'une couche d'un matériau à changement de phase, présentant un accroissement de volume d'au moins 2% entre une phase cristalline et une phase amorphe. Le procédé est caractérisé en ce qu'il comprend également une étape de personnalisation du moule, obtenue en faisant transiter localement la couche de matériau à changement de phase depuis sa phase cristalline vers sa phase amorphe afin d'y former des motifs en relief.

L'invention comprend un tel moule ainsi qu'un procédé de modification d'un tel moule.

## Description

La présente invention concerne, en général, la lithographie par nanoimpression utilisée par l'industrie des micro et nanotechnologies. Elle concerne plus particulièrement un procédé de réalisation d'un moule d'impression nanométrique que l'on peut aisément ajuster, corriger voire reconfigurer.

### ÉTAT DE LA TECHNIQUE

L'industrie des micro et nanotechnologies fait appel à la lithographie lors de nombreuses étapes de fabrication des dispositifs qu'elle produit, afin de définir des formes et des tailles de motifs créés dans les différentes couches de matériaux constituant ces dispositifs.

Pour atteindre les dimensions nanométriques requises pour soutenir l'intégration toujours croissante d'un plus grand nombre de composants dans un même dispositif, l'industrie des micro et nanotechnologies doit maintenant faire appel à des techniques qui vont au-delà de la lithographie optique classique basée, depuis son origine dans les années 60, sur l'utilisation de masques qui servent à illuminer, dans la gamme des longueurs d'ondes visibles, des résines photosensibles dans lesquelles on reproduit les motifs à graver. Notamment, pour limiter la diffraction de la lumière au travers des masques, on a recours actuellement à des longueurs d'ondes plus courtes : ultraviolet et ultraviolet lointain, voire rayons X ; et à des techniques complexes comme, par exemple, la lithographie en immersion qui demandent des investissements considérables pour leur développement et leur mise en oeuvre industrielle.

Une technique connue, qui ne nécessite pas l'emploi de masques et qui permet effectivement de définir les motifs avec une résolution compatible avec les niveaux d'intégration souhaités c'est-à-dire, actuellement, quelques centaines ou quelques dizaines de nanomètres (nm = 10⁻⁹ mètre), utilise un faisceau d'électrons pour impressionner la résine. Il s'agit là toutefois d'une technique qui est intrinsèquement lente puisqu'il faut alors écrire séquentiellement chacun des motifs qui, à chaque étape de fabrication, constituent le dispositif à fabriquer. Sachant que les circuits intégrés les plus denses contiennent actuellement des milliards de transistors, et donc au moins autant de motifs, l'impression séquentielle de chacun des motifs est incompatible avec une production industrielle. De fait, la lithographie par faisceau d'électrons est le plus souvent réservée à la fabrication de masques eux-mêmes ou à la fabrication de circuits expérimentaux en laboratoire.

Dès le milieu des années 90, une technique très différente de la lithographie optique, qui permet notamment de s'affranchir complètement des problèmes de diffraction mentionnés ci-dessus, a été inventée par le Professeur Stephen Y. CHOU. Le principe de cette technique dite « lithographie par nanoimpression » a été dévoilé dans plusieurs publications dont notamment celle intitulée « Nanoimprint Lithography » dans « Journal of Vacuum Science and Technology » référence B 14(6), Nov./Dec, 1996. La lithographie par nanoimpression fait désormais partie de la feuille de route internationale des technologies pour les semi-conducteurs ou ITRS « international technology roadmap for semiconductors ».

Un grand avantage de la lithographie par nanoimpression est qu'elle permet, comme avec les masques ou réticules de la lithographie optique et contrairement à la lithographie par faisceau d'électrons, de reproduire tous les motifs d'un dispositif simultanément à partir d'un moule. Le moule est par exemple utilisé pour imprimer des monomères ou des polymères thermodurcissables ou thermoplastiques chauffés. Après refroidissement le moule peut être enlevé, les motifs imprimés restent en place sans déformations notables. On peut alors transférer ces motifs par gravure avec la même précision dans la couche sous jacente du dispositif en cours de fabrication. La précision de l'impression est donc celle du moule. Celui-ci peut donc être réalisé avec une technique de lithographie comme celle mentionnée ci-dessus par faisceau d'électrons qui permet effectivement d'atteindre la résolution souhaitée de quelques dizaines de nanomètres. Ainsi, la lithographie par nanoimpression est une technique très intéressante pour toute l'industrie des micro et nanotechnologies puisqu'elle combine la précision de définition des motifs qu'il est possible d'atteindre avec la lithographie par faisceau d'électrons avec la vitesse de production de la lithographie optique utilisant des masques ou des réticules qui permettent de reproduire simultanément sur une plaque tous les motifs d'un dispositif en cours de fabrication.

Toutefois, l'obtention d'un moule d'impression présentant une forte résolution (typiquement de l'ordre de quelques dizaines ou centaines de nanomètres) est une opération longue et coûteuse et ne se justifie que pour une production industrielle conséquente. En outre, lorsque l'on souhaite modifier le design d'un moule, il faut nécessairement refaire entièrement le moule, ce qui accroît encore le coût des dispositifs produits par nanoimpression.

Par conséquent, il serait particulièrement avantageux de proposer une solution pour réduire le coût lié à la modification de motifs présents sur un moule. La présente invention vise à proposer une telle solution.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

La présente invention propose un procédé de fabrication d'un moule de lithographie par nanoimpression, comprenant une étape de dépôt sur un support appartenant au moule d'une couche de matériau à changement de phase présentant une variation de volume d'au moins 2% entre une phase cristalline et une phase amorphe, de sorte qu'une modification locale de la phase du matériau à changement de phase forme un motif à la surface de ladite couche.

Ainsi des motifs peuvent être formés tout au long de la vie du moule, notamment après des premières utilisations du moule. L'invention permet par conséquent une modification des motifs du moule. Ce dernier peut donc être aisément reconfiguré.

Le motif est apte à être transféré par impression dans une couche dans laquelle est pressé le moule comprenant le support et la couche d'un matériau à changement de phase.

De manière optionnelle et avantageuse, le procédé comprend une étape de personnalisation du moule au cours de laquelle on forme des motifs en relief en faisant transiter localement la couche de matériau à changement de phase depuis l'une des phases vers l'autre phase. De préférence, l'étape de personnalisation consiste à faire transiter localement la couche de matériau à changement de phase depuis sa phase cristalline vers sa phase amorphe.

De manière également optionnelle, le procédé comprend, pour au moins un motif en relief, une étape d'effacement au moins partiel du motif en relief. Ainsi, le procédé de formation des motifs est réversible. L'invention permet donc de faire apparaître ou disparaître des motifs de sorte à ajuster ou corriger un moule. L'invention permet également, à partir d'un premier moule, de fabriquer un deuxième moule présentant des motifs différents du premier. Le coût d'obtention d'un deuxième moule est donc limité puisque ce dernier provient d'un moule existant. L'invention offre donc la possibilité d'utiliser la lithographie par nano-impression même pour des petites séries. Elle présente donc un intérêt considérable d'un point de vue industriel.

Par ailleurs, le procédé selon l'invention présente un nombre limité d'étapes pour obtenir le moule.

Selon un autre aspect, l'invention porte sur moule de lithographie par nanoimpression comprenant un support et une couche surmontant le support. La couche est formée par un matériau à changement de phase présentant un accroissement de volume d'au moins 2% entre une phase cristalline et une phase amorphe, la couche étant configurée de sorte qu'une modification locale de la phase du matériau à changement de phase forme un motif à la surface de ladite couche.

De manière facultative, le moule selon l'invention peut présenter au moins l'une quelconque des caractéristiques optionnelles énoncées ci-dessous.

De préférence, le moule comprend des motifs formés par la couche en matériau à changement de phase, la phase du matériau à changement de phase au niveau des motifs étant différente de la phase du matériau à changement de phase au niveau des portions de la couche du matériau à changement de phase qui ne forment pas de motifs.

De préférence, la couche de matériau à changement de phase présente une première face tournée au regard du support et une deuxième face qui est opposée à la première face et qui est recouverte par une couche de protection. Avantageusement, la couche de protection est une couche en un matériau diélectrique.

De préférence, le moule comprend une couche de régulation thermique disposée entre la couche du matériau à changement de phase et le support. Avantageusement, la couche de régulation thermique est une couche en un matériau diélectrique.

De préférence, le moule comprend une couche métallique disposée entre la couche du matériau à changement de phase et le support et de préférence directement au contact du support.

Selon un autre aspect, l'invention porte sur un procédé de modification d'un moule tel que décrit précédemment, le moule comprenant des motifs en relief formés dans la couche de matériau à changement de phase, le procédé comprenant une étape de modification locale de la phase du matériau à changement de phase de sorte à faire disparaître au moins partiellement un motif existant ou de sorte à étendre un motif existant ou de sorte à former un nouveau motif à la surface de ladite couche de matériau à changement de phase.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
- Les figures 1a à 1 c décrivent le principe d'obtention d'un moule d'impression reconfigurable selon un exemple de réalisation de l'invention.
- Les figures 2a à 2d illustrent les étapes de reconfiguration du moule selon un exemple de réalisation de l'invention.
- La figure 3 indique des exemples d'alliages à changement de phase particulièrement appropriés pour réaliser un moule reconfigurable selon l'invention.
- La figure 4 montre différentes structures de moules reconfigurables selon l'invention.
- La figure 5 illustre des résultats expérimentaux où des motifs en relief sont créés à l'aide d'un laser afin de personnaliser un moule reconfigurable.
- La figure 6 illustre d'autres résultats expérimentaux où des motifs en relief de dimension et de hauteurs différentes sont obtenus avec des réglages différents du laser d'écriture.
- La figure 7 illustre l'opération d'effacement des motifs du moule à l'aide du laser d'écriture.

Les dessins joints sont donnés à titre d'exemples et ne sont pas limitatifs de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
Préférentiellement, la couche de matériau à changement de phase est au moins partiellement dans sa phase cristalline avant l'étape de personnalisation.

Avantageusement, la formation des motifs est obtenue par irradiation locale de la couche de matériau à changement de phase à l'aide d'un laser d'écriture.

De préférence, la couche de matériau à changement de phase présente un accroissement de volume supérieur à 4% et de préférence supérieur 5% entre sa phase cristalline et sa phase amorphe.

Selon un mode de réalisation, l'étape d'effacement au moins partiel est appliquée à tous les motifs. De préférence, l'étape d'effacement est effectuée dans un four de recuit qui remet complètement la couche de matériau à changement de phase dans sa phase cristalline faisant ainsi disparaître l'ensemble des motifs.

Selon un autre mode de réalisation, l'étape d'effacement est localisée. Elle est effectuée à l'aide d'un laser. Avantageusement, le laser est le laser utilisé pour obtenir la formation des motifs.

Avantageusement, le procédé comprend une étape de dépôt d'une couche supérieure d'un matériau diélectrique. Cette couche est déposée sur la couche de matériau à changement de phase. De préférence, l'étape de dépôt d'une couche supérieure de matériau diélectrique est effectuée après l'étape de dépôt de la couche de matériau à changement de phase sur le support et avant l'étape de personnalisation du moule.

Avantageusement, l'étape de dépôt d'une couche de matériau à changement de phase est précédée d'une étape de dépôt d'une couche inférieure d'un matériau diélectrique.

Avantageusement, l'étape de dépôt d'une couche de matériau à changement de phase et/ou l'étape de dépôt d'une couche inférieure de matériau diélectrique est de plus précédée d'une étape de dépôt d'une couche métallique.

Si le moule ne comprend pas de couche inférieure d'un matériau diélectrique entre le support et la couche de matériau à changement de phase, alors cette dernière est de préférence disposée directement au contact du support. Dans le cas contraire, elle est de préférence directement au contact de la couche inférieure de matériau diélectrique. Cette dernière est de préférence directement au contact du support ou au contact d'une couche métallique.

Si le moule ne comprend pas de couche d'un matériau diélectrique supérieure, alors une face de la couche de matériau à changement de phase est au contact du milieu ambiant. Si la couche de matériau à changement de phase est recouverte d'une couche supérieure d'un matériau diélectrique, alors c'est cette couche supérieure de matériau diélectrique qui présente une face au contact du milieu ambiant.

De préférence, le matériau à changement de phase est pris parmi les alliages binaires ou ternaires chalcogénures. En particulier, les alliages comprenant deux ou trois éléments parmi le germanium (Ge), le tellure (Te) et l'antimoine (Sb) s'avèrent particulièrement avantageux pour mettre en oeuvre l'invention. L'invention s'étend également aux alliages comprenant deux ou trois de ces éléments ainsi que d'autres éléments.

Dans un mode de réalisation particulier, le moule présente une transparence supérieure à 0%. On peut ainsi utiliser le moule dans un procédé de nano impression assisté par un flux lumineux, typiquement des UV. Cela permet par exemple de stabiliser la résine pendant le pressage du moule. Avantageusement, la transparence du moule est supérieure à 60%.

Selon un mode de réalisation particulier, la couche présente une transparence au moins supérieure à 40% et de préférence au moins supérieure à 60%. Ainsi, le moule peut être utilisé pour effectuer une étape de nano-impression assisté par un rayonnement ultraviolet, ou pour un procédé de photolithographie combiné à de la nano-impression. De manière connue, dans un procédé de ce type, on presse le moule dans une résine et on pratique une insolation sélective de la résine à travers le moule.

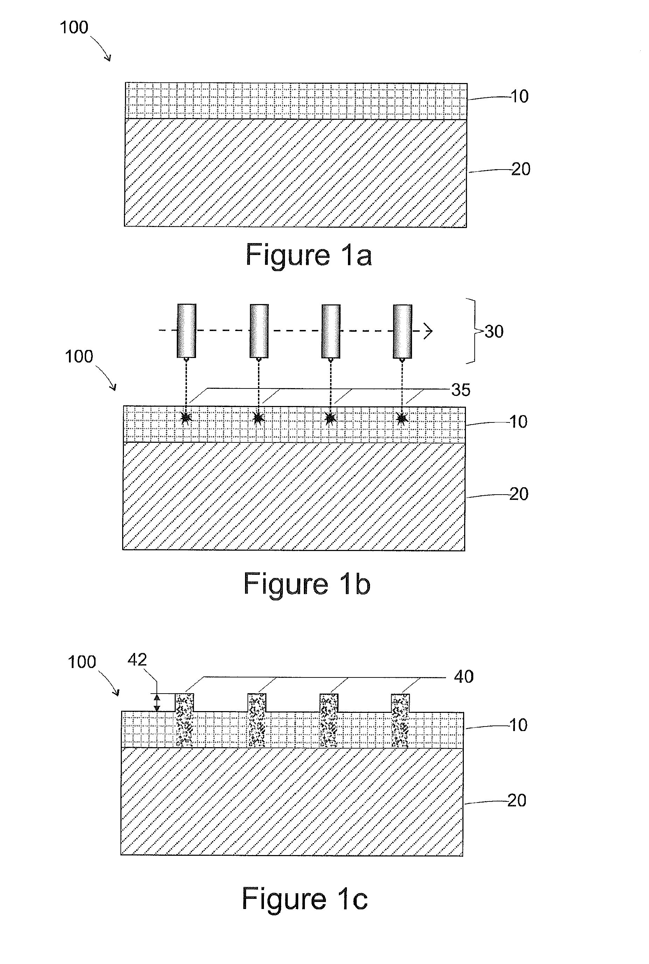

Les **figures 1a, 1b** et **1c** décrivent le principe d'obtention d'un moule d'impression reconfigurable selon l'invention.

Pour réaliser un moule reconfigurable l'invention utilise un type de matériaux choisi parmi ceux qui sont dits à « changement de phase ». Ce sont le plus couramment des alliages chalcogénures à base de tellure (Te). Ces matériaux sont actuellement utilisés dans les mémoires optiques réenregistrables qui se présentent sous forme de disques compacts ou « CD » et de disques optiques numériques connus sous leurs acronymes de « DVD » et « Blu-ray ». Ils sont aussi utilisés dans les mémoires électriques non-volatiles de type « PCRAM », acronyme de l'anglais « phase change random access memory » c'est-à-dire « mémoire à accès aléatoire à changement de phase ». L'intérêt de ces matériaux est qu'on peut les faire évoluer très rapidement, typiquement en quelques dizaines de nanosecondes, entre un état amorphe et un état cristallin dans lesquels ils montrent des propriétés très différentes. Dans le cas des disques optiques numériques c'est le fort contraste de réflexion optique entre la phase amorphe et la phase cristalline qui permet le codage de l'information. Dans le cas des mémoires électriques c'est la grande différence de résistance entre les deux phases qui est exploitée. La réversibilité des transformations de phase peut être garantie sur un très grand nombre de cycles. Ce nombre est typiquement supérieur à un million de cycles.

Les propriétés optiques et électriques mentionnées ci-dessus qui sont exploitées respectivement par les disques optiques numériques et les mémoires de type PCRAM, ne sont pas les seules propriétés qui sont fortement dépendantes de l'état dans lequel le matériau à changement de phase se trouve. En particulier, il s'est avéré que ces matériaux présentent également de forts contrastes de densité volumique (p) entre les deux phases, la densité de la phase amorphe (ρₐₘₒᵣₚₕₑ) étant inférieure à la densité de la phase cristalline (ρ_{cristal}). Le volume occupé par une même quantité de matériau est donc plus important dans la phase amorphe que dans la phase cristalline. Ce comportement est considéré comme étant un sérieux inconvénient car il peut créer en fonction des applications et structures dans lesquelles le matériau est utilisé des contraintes mécaniques répétitives à chaque cycle de transformation qui sont susceptibles de limiter la durée de vie d'un dispositif qui l'utilise. L'invention tire au contraire avantage de cette variation de densité volumique pour réaliser un moule d'impression reconfigurable.

Comme illustré sur les figures 1a à 1c l'invention consiste à utiliser une structure adaptée de couches, de préférence minces qui, dans sa forme la plus simple représentée sur la figure 1a, inclut simplement une couche 10 d'un matériau à changement de phase. Ce dernier est déposé sur un support 20, également désigné substrat, qui constitue le support mécanique d'un moule 100 selon la présente invention. On notera que l'invention s'étend à tous procédés dans lesquels le support 20 est supprimé ou est substitué par, ou en partie reporté sur un autre support.

Il est précisé que, dans le cadre de la présente invention, le terme « sur » ne signifie pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Initialement, la couche 10 de matériau à changement de phase est dans son état cristallin, ou remise dans cet état après dépôt de cette couche, par exemple en chauffant la structure 100 au dessus de la température de cristallisation du matériau à changement de phase qui la constitue. Le moule reconfigurable est alors vierge de tout motif.

Comme montré sur la figure 1 b un échauffement local de la couche 10 de cette structure, par exemple par irradiation laser 30, va permettre de faire transiter dans toutes les zones irradiées 35 le matériau à changement de phase vers sa phase désordonnée amorphe moins dense que la structure cristalline initiale.

Comme illustré sur la figure 1c la relaxation des contraintes fait apparaître au niveau de ces zones une topographie de surface sous forme de reliefs 42 de l'ordre de 50 nm environ. Les motifs 40 amorphes en relief ainsi réalisés vont pouvoir alors être utilisés pour une opération de lithographie par nanoimpression ultérieure utilisant la structure 100 comme moule d'impression. La réalisation des motifs 40 amorphes, qui correspond à l'étape d'écriture du moule reconfigurable, se fait donc par exemple au moyen d'un faisceau laser 30 qui va être piloté par des moyens mécaniques, électroniques et logiciels standard (non représentés) afin d'irradier successivement toutes les zones de la couche 10 de matériau à changement de phase où l'on doit former les motifs 40 en relief destinés à être imprimer.

La longueur d'onde et l'ouverture numérique de l'objectif de focalisation définissent la résolution du système optique et donc la dimension du spot laser. Le diamètre efficace du spot laser détermine la dimension latérale du motif amorphe, c'est-à-dire la dimension selon une direction parallèle au plan de la surface de la couche 10. Chaque spot laser permet de créer un plot de matériau amorphe ayant au maximum la dimension de ce dernier. Le diamètre attendu du plot sera fonction de la puissance laser utilisée mais restera de dimension inférieure à la taille du spot laser. Par exemple, avec un système optique du type de ceux utilisés avec les disques optiques numériques « Blu-ray », c'est-à-dire de longueur d'onde À = 405 nm et d'ouverture numérique ON = 0,85, les dimensions attendues des plots amorphes seront inférieures à 386 nm comme indiqué dans le tableau ci-après.

| λ | ON | Diamètre efficace du spot laser | Diamètre attendu des plots amorphes | Puissance laser disponible |
|---|---|---|---|---|
| 650 nm | 0,6 | 870 nm | <870nm | < 40 mW |
| 405 nm | 0,85 | 386 nm | < 386 nm | < 15 mW |
| 405 nm | 0,75 | 443 nm | < 443 nm | <70mW |

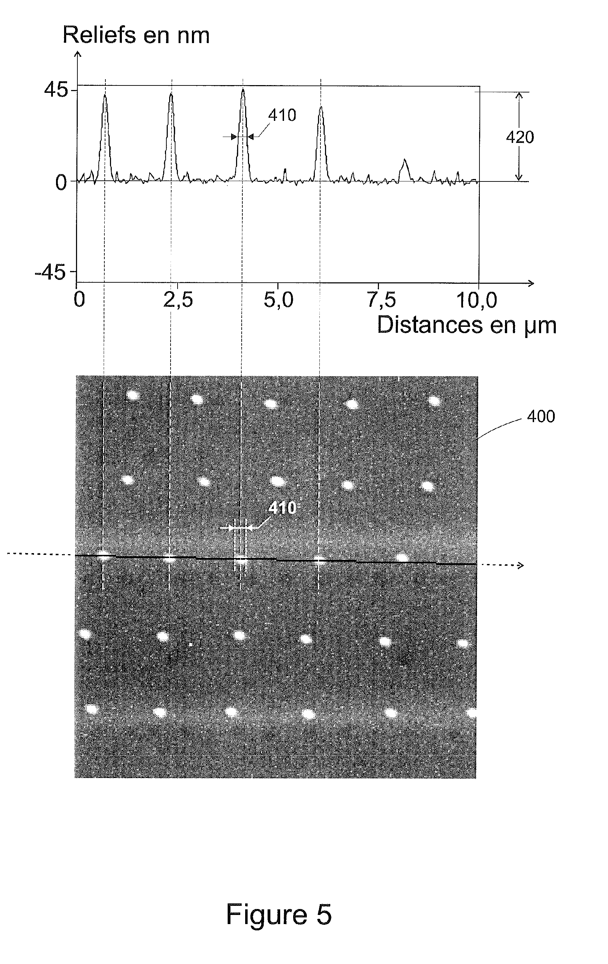

On verra ci-après qu'il est possible de faire varier la dimension des plots amorphes en modifiant les paramètres d'irradiation, c'est-à-dire la puissance et la durée de l'impulsion. Comme mentionné dans la description de la figure 5 les plots obtenus ont un diamètre de l'ordre de 200 nm. Une modification appropriée des conditions d'irradiation consistant notamment en une diminution de la puissance jusqu'à environ 35 mW permettent l'obtention de plots de l'ordre de 180 nm avec la structure très simple illustrée sur les figures 1a à 1 c comprenant une couche de matériau à changement de phase 10 déposée sur un substrat 20 de silicium.

Une structure optique plus complexe que celle utilisée pour l'obtention des résultats illustrés sur les figures, avec puits thermique par exemple, ainsi que l'utilisation d'un laser ayant une résolution optique plus importante (ON=0,85) permettent la réalisation de plots amorphes de l'ordre de 100 nm voire de dimension inférieure.

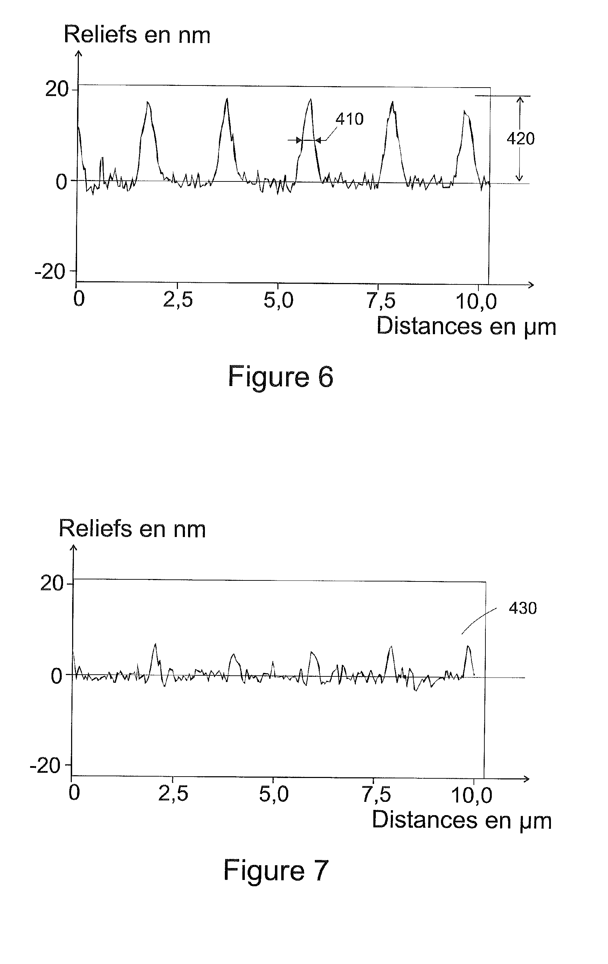

Il est également intéressant de noter que l'on pourra moduler la topographie et obtenir des motifs en relief de hauteurs variables en fonction de la puissance utilisée comme on le verra dans les figures 5 et 6.

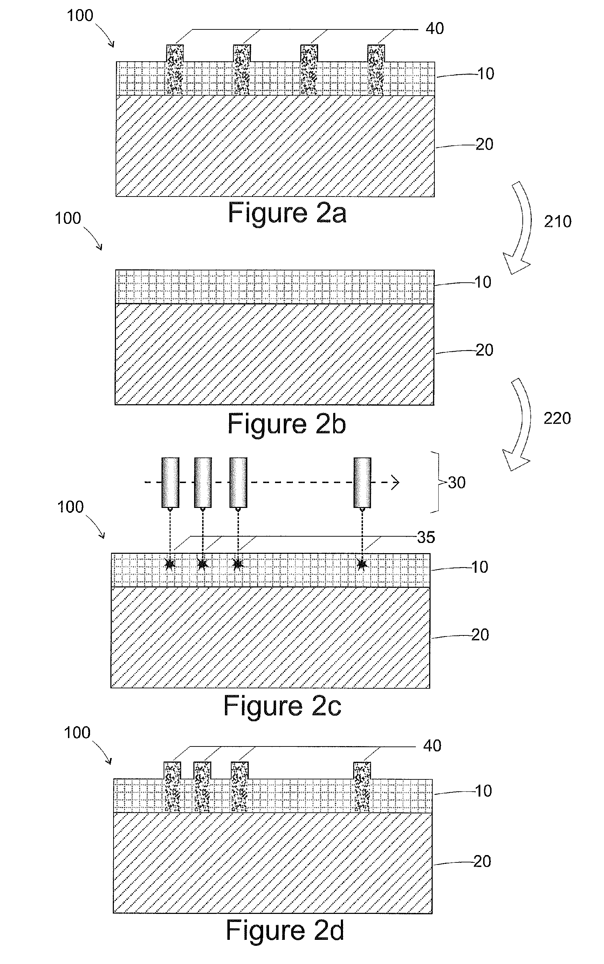

L'intérêt d'utiliser un matériau à changement de phase est que le processus de personnalisation du moule est devenu réversible. En portant la structure 100, totalement ou localement, au dessus de la température de cristallisation du matériau à changement de phase celui-ci va recristalliser et retrouver sa densité initiale, effaçant ainsi la topographie de surface et les motifs qui y étaient inscrits. Les **figures 2a à 2d** illustrent les étapes de reconfiguration d'un moule 100 selon l'invention. Partant d'une personnalisation existante, par exemple celle de la figure 2a, on procède dans une première étape 210 à son effacement. Comme indiqué ci-dessus l'effacement, opération qui consiste à recristalliser la couche 10, peut se faire de manière globale en réalisant un recuit thermique dans un four de recuit standard qui sera porté à une température typiquement comprise entre 150 et 200°C en fonction de la composition de l'alliage à changement de phase utilisé pour la couche 10.

L'effacement peut aussi se faire, comme l'écriture, de façon locale. De préférence on utilise alors le même laser et la même infrastructure de pilotage. Dans ce cas, le laser est réglé pour délivrer une puissance environ deux fois moins élevée que celle utilisée pour l'écriture permettant ainsi la recristallisation et l'effacement successifs de chacun des plots amorphes. Dans les deux cas le résultat est celui montré sur la figure 2b où l'on a de nouveau un moule vierge de tout motif.

Toutefois, on notera ici qu'un avantage de l'invention est qu'il est aussi possible de ne procéder avec le laser d'écriture qu'à un effacement partiel de la personnalisation dans le cas où seule une correction de certains motifs 40 doit être effectuée.

On peut ensuite procéder à une nouvelle personnalisation du moule reconfigurable 100 dans les mêmes conditions que celles décrites dans les figures 1 b et 1 c. Le système de pilotage du laser 30 étant chargé avec une personnalisation complètement différente, ou avec des corrections d'un moule existant, l'étape d'écriture 220 est effectuée et consiste à irradier toutes les zones 35 où il faut créer un relief 40. A l'issue de cette étape le moule 100 est reconfiguré par exemple comme illustré sur la figure 2d.

Il apparaît ainsi clairement de la description qui précède que le moule 100 finalisé comprend la couche 10 de matériau à changement de phase ainsi que le support 20.

La réversibilité ou cyclabilité des transformations entre les phases amorphe et cristalline est extrêmement élevée pour les matériaux à changement de phase considérés. Les mémoires optiques actuellement commercialisées atteignent une durabilité de 10⁶ cycles tandis que les spécifications des mémoires électriques requièrent potentiellement une cyclabilité de 10¹³ cycles. La durée de vie d'un moule reconfigurable selon l'invention est donc potentiellement extrêmement élevée et n'est en rien limitée par le nombre de reconfiguration qu'on lui fera subir.

On notera aussi que la personnalisation est obtenue en mettant en oeuvre des procédés simples et peu coûteux en comparaison des procédés de lithographie et de gravure que l'on utilise pour réaliser un moule standard. L'exposition laser ne nécessite pas de travailler dans une atmosphère très contrôlée comme celle des salles « blanches » où l'on pratique la photolithographie. Elle ne nécessite pas non plus d'avoir à créer un vide pour former les motifs les plus petits et le système d'écriture par laser n'a seulement besoin que de survoler le substrat pour le structurer sans aucun contact avec ce dernier. L'exposition laser peut être effectuée sur des substrats de n'importe quelle taille et forme. De même, un recuit thermique est une étape simple à faible coût et qui est très facile à mettre en oeuvre.

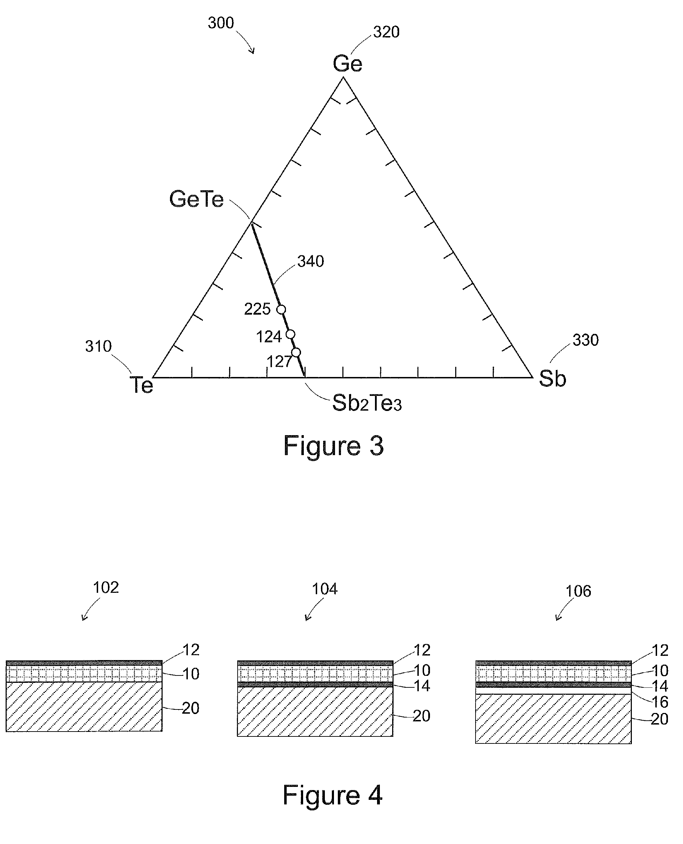

La **figure 3** illustre à l'aide d'un diagramme 300 d'alliages ternaires à base de tellure (Te) les matériaux à changement de phase qui sont les plus appropriés pour constituer la couche 10 d'un moule reconfigurable selon l'invention.

Les alliages ternaires chalcogénures considérés comprennent outre le tellure (Te) 310, du germanium (Ge) 320 et de l'antimoine (Sb) 330. Les alliages qui conviennent le mieux, c'est-à-dire ceux qui ont la variation volumique la plus importante, sont de préférence choisis le long de la ligne 340 entre les alliages binaires GeTe et Sb₂Te₃ Il s'agit notamment du Ge₂Sb₂Te₅ référencé 225, du Ge₁Sb₂Te₄ référencé 124, et du Ge₁Sb₂Te₇ référencé 127. La variation volumique de l'alliage binaire GeTe est la plus importante constatée. On a pu constater également que les matériaux qui ont le plus fort contraste optique sont aussi ceux qui présentent une grande variation de densité volumique.

Les matériaux à changement de phase susceptibles de convenir doivent présenter une variation volumique d'au moins 2% entre la phase cristalline et la phase amorphe, de préférence supérieure à 4% et par exemple comprise entre 5% et 20%.

Il a en effet été constaté expérimentalement qu'une faible variation volumique du matériau à changement de phase suffisait pour créer des reliefs proportionnellement beaucoup plus importants comme on le verra dans les figures suivantes. Par exemple, on a constaté que des reliefs de l'ordre de 50 nm peuvent être formés sur une couche de matériau à changement de phase dont l'épaisseur n'est que de 100 nm et pour une variation volumique du matériau de seulement 10% entre les états cristallin et amorphe. Il a été conjecturé que c'est le passage à l'état liquide du matériau à changement de phase au cours de la transition entre les états cristallin et amorphe qui permet d'expliquer ce comportement particulier. Il est en effet probable que le passage à l'état liquide des plots fait intervenir des phénomènes liés à la mécanique des fluides qui, à l'échelle micrométrique ou nanométrique, créent des mécanismes de déstabilisation de la surface liquide. La modélisation de tels phénomènes est connue de l'homme du métier. Elle nécessite de connaître deux propriétés du matériau à changement de phase dans son état liquide, c'est-à-dire : son énergie de surface qui s'exprime en Joules par mètre carré (J/m²) et sa viscosité qui s'exprime en Pascal-seconde (Pa.s).

La **figure 4** montre des structures plus élaborées de moules reconfigurable selon l'invention.

La structure 102 inclut une couche diélectrique supérieure 12 qui est déposée sur la couche 10 de matériau à changement de phase. La couche diélectrique supérieure 12 est destinée à protéger la couche de matériau à changement de phase contre le vieillissement et l'oxydation. Cette couche permet également de protéger la structure lorsque le matériau à changement de phase est porté à la fusion lors des transitions entre les phases cristalline et amorphe notamment en permettant de limiter l'amplitude de la déformation liée à la déstabilisation trop importante de la surface quand celle-ci transite par sa phase liquide. Le substrat 20 est typiquement fait de silicium. La couche diélectrique 12 doit pouvoir supporter les variations volumiques lors des transitions de phase. Elle est de préférence faite d'un matériau à structure granulaire fine. L'emploi d'oxydes pour cette couche, et en particulier l'oxyde de silicium (SiO₂) est privilégié.

La structure 104 inclut une couche diélectrique de part et d'autre de la couche 10 de matériau à changement de phase, c'est-à-dire qu'elle comprend aussi une couche diélectrique 14 inférieure. Dans ce mode de réalisation, la couche 10 de matériau à changement de phase présente une face inférieure tournée au regard du support 20 et au contact de la couche diélectrique 14 inférieure. Elle présente également une face supérieure tournée au regard du milieu ambiant et au contact de la couche diélectrique 12 supérieure.

De manière additionnelle, la structure 106 inclut de plus une couche métallique 16 entre le substrat 20 et la couche diélectrique 14 inférieure. Cette couche métallique 16 est de préférence directement au contact de la couche diélectrique 14 inférieure et du support 20. Cette couche métallique 16 peut également être disposée directement au contact de la couche 10 de matériau à changement de phase dans le cas où le moule ne comprend pas de couche diélectrique 14 inférieure.

Dans ces structures la couche diélectrique supérieure, en plus de son rôle de protection, a un rôle optique. Suivant son épaisseur, elle peut servir à régler l'absorption optique de la couche 10 de matériau à changement de phase. En ce qui concerne la couche diélectrique inférieure 14 qui est située entre le silicium du substrat et le matériau à changement de phase dans la structure 104 ; ou entre la couche métallique 16 et la couche 10 dans la structure 106, sa fonction est essentiellement thermique. Elle permet de réguler les échanges de chaleur entre la couche à changement de phase et le silicium ou le puits thermique métallique. Le silicium et la couche métallique, de très bonne conductivité thermique, permettent d'évacuer très rapidement la chaleur à la fin de l'impulsion laser et autorisent la formation de la phase amorphe

Le métal de la couche 16 pourra être choisi parmi la liste suivante : l'aluminium (Al), l'argent (Ag), le cuivre (Cu), le nickel (Ni), le zinc (Zn), le chrome (Cr), le tungstène (W), le tantale (Ta), le titane (Ti), la platine (Pt) le palladium (Pd), l'or (Au) et tous les alliages de ceux-ci. Le diélectrique de la couche 14 inférieure pourra être choisi parmi tous les oxydes, nitrures ou oxi-nitrures des éléments métalliques cités ci-dessus ainsi que parmi tous les oxydes, nitrures et oxi-nitrures des éléments semi-conducteurs appartenant à la colonne IV du tableau périodique des éléments contenant notamment le silicium (Si) et le germanium (Ge).

Typiquement, dans les structures 100, 102, 104 et 106 l'épaisseur de la couche 10 de matériau à changement de phase est comprise entre 20 et 300 nm et de préférence entre 50 et 150 nm. Celle des couches diélectriques est comprise entre 2 et 100 nm et de préférence entre 5 et 50 nm. La couche métallique 16 est supérieure ou égale à 200 nm et de préférence supérieure ou égale à 100 nm.

La **figure 5** illustre des résultats expérimentaux observés avec une structure de type 106 comme montré sur la figure 4. La structure est plus précisément celle décrite ci-après :
- Le substrat 20 est fait de silicium.
- La couche métallique 16 est constituée de tungstène (W) d'une épaisseur de 100 nm.
- La couche diélectrique inférieure 14 est faite d'oxyde de silicium (SiO2) d'une épaisseur de 20 nm.
- La couche de matériau à changement de phase 10 est constituée de l'alliage binaire GeTe sur une épaisseur de 100 nm.
- La couche diélectrique supérieure 12 est aussi faite d'oxyde de silicium (SiO2). Elle est d'une épaisseur de 20 nm.
- Les couches minces sont obtenues par dépôt physique en phase vapeur ou PVD, acronyme de l'anglais « physical vapor déposition ».
- La structure 106 subit un recuit thermique préalable de 1 heure à 200°C afin de cristalliser la couche de GeTe formant la couche 10 de matériau à changement de phase. Celle-ci est en effet amorphe à l'issue du dépôt PVD.

Une matrice de plots 400 est ensuite réalisée sur la surface de la structure 106 au moyen d'impulsions laser de puissance et durée contrôlées, c'est-à-dire, dans l'expérimentation illustrée dans la figure 5 : Pₗₐₛₑᵣ = 45 mW, durée de l'impulsion tₚᵤₗₛₑ = 65 ns. Le laser est un laser bleu de longueur d'onde À = 405 nm et d'ouverture numérique ON = 0,75.

Les mesures sont faites à l'aide d'un microscope à force atomique ou AFM, acronyme de l'anglais « atomic force microscope ». Le diamètre des plots 410 est de l'ordre de 200 nm avec une hauteur moyenne 420 de 45 nm.

La **figure 6** montre qu'avec une structure de type 106, en tous points identique à la précédente, il est possible de modifier à la fois la dimension des plots amorphes et leur hauteur. Les conditions d'écriture sont dans ce cas : Pₗₐₛₑᵣ = 70 mW, durée de l'impulsion tₚᵤₗₛₑ = 120 ns. On obtient alors des plots dont le diamètre 410 est plus grand, de l'ordre de 350 nm, mais d'une hauteur 420 moindre, d'environ 20 nm.

La **figure 7** illustre la réversibilité du processus d'amorphisation des plots à l'aide du laser d'écriture. La matrice de plots précédente, celle obtenue avec les conditions de la figure 6, est ensuite recristallisée au moyen d'impulsions laser de plus faible puissance : Pₗₐₛₑᵣ = 30 mW et d'une durée plus longue : tₚᵤₗₛₑ = 200 ns. Ces impulsions laser sont appliquées sur chacun des plots amorphes créés précédemment. Une nouvelle observation 430 à l'aide du microscope à force atomique montre que les plots amorphes ont alors quasiment disparus. Le matériau a donc bien recristallisé et la topographie de surface est pratiquement redevenue plane, c'est-à-dire qu'elle est à nouveau celle de la matrice cristalline initiale. On remarquera que les reliefs résiduels que l'on peut néanmoins observer dans cette expérimentation particulière peuvent être encore améliorés en ajustant la puissance laser de recristallisation et en contrôlant plus précisément les décalages entre les spots de recristallisation et ceux qui avaient créés initialement les plots amorphes.

La présente invention n'est pas limitée aux modes de réalisation précédemment décrits mais s'étend à tout mode de réalisation conforme à son esprit.

## Revendications

1. Procédé de fabrication d'un moule (100) de lithographie par nanoimpression, le procédé étant **caractérisé en ce qu'**il comprend une étape de dépôt sur un support (20) du moule (100) d'une couche (10) de matériau à changement de phase présentant une variation de volume d'au moins 2% entre une phase cristalline et une phase amorphe, de sorte qu'une modification locale de la phase du matériau à changement de phase forme un motif (40) à la surface de ladite couche (10) appartenant au moule (100), le procédé étant également **caractérisé en ce qu'**il comprend une étape de personnalisation (220) du moule (100) au cours de laquelle on forme des motifs (40) en relief, en faisant transiter localement la couche (10) de matériau à changement de phase depuis l'une des phases vers l'autre phase.

2. Procédé selon la revendication précédente dans lequel l'étape de personnalisation (220) consiste à faire transiter localement la couche (10) de matériau à changement de phase depuis sa phase cristalline vers sa phase amorphe.

3. Procédé selon l'une quelconque des deux revendications précédentes dans lequel la couche (10) de matériau à changement de phase est au moins partiellement dans sa phase cristalline avant l'étape de personnalisation (220).

4. Procédé selon l'une quelconque des trois revendications précédentes dans lequel la formation des motifs (40) est obtenue par irradiation (30) locale de la couche (10) de matériau à changement de phase à l'aide d'un laser d'écriture.

5. Procédé selon l'une quelconque des revendications précédentes dans lequel la couche (10) de matériau à changement de phase présente un accroissement de volume supérieur à 4% entre sa phase cristalline et sa phase amorphe.

6. Procédé selon l'une quelconque des revendications précédentes comprenant, pour au moins un motif (40) en relief, une étape d'effacement (210) au moins partiel du motif (40) en relief.

7. Procédé selon la revendication précédente dans lequel l'étape d'effacement (210) au moins partiel est appliquée à tous les motifs (40), et dans lequel l'étape d'effacement (210) est de préférence effectuée dans un four de recuit qui remet complètement la couche (10) de matériau à changement de phase dans sa phase cristalline faisant ainsi disparaître l'ensemble des motifs (40).

8. Procédé selon la revendication 6 dans lequel l'étape d'effacement est effectuée sur certains motifs seulement et à l'aide d'un laser.

9. Procédé selon la revendication 4 comprenant, pour au moins un motif (40) en relief, une étape d'effacement (210) au moins partiel du motif (40) en relief, l'étape d'effacement étant effectuée à l'aide du laser utilisé pour obtenir la formation des motifs (40).

10. Procédé selon l'une quelconque des revendications précédentes comprenant une étape de dépôt d'une couche (12) supérieure d'un matériau diélectrique sur la couche (10) de matériau à changement de phase et dans lequel l'étape de dépôt d'une couche (12) supérieure de matériau diélectrique est de préférence effectuée : après l'étape de dépôt de la couche (10) de matériau à changement de phase sur le support (20) et avant l'étape de personnalisation (220) du moule.

11. Procédé selon l'une quelconque des revendications précédentes dans lequel l'étape de dépôt d'une couche (10) de matériau à changement de phase est précédée d'une étape de dépôt d'une couche (14) inférieure d'un matériau diélectrique.

12. Procédé selon la revendication précédente dans lequel l'étape de dépôt d'une couche (10) de matériau à changement de phase et/ou l'étape de dépôt d'une couche (14) inférieure de matériau diélectrique est de plus précédée d'une étape de dépôt d'une couche métallique (16).

13. Procédé selon l'une quelconque des revendications précédentes dans lequel le matériau à changement de phase est pris parmi les alliages binaires ou ternaires chalcogénures.

14. Moule (100, 102, 104, 106) de lithographie par nanoimpression comprenant un support (20) et une couche (10) surmontant le support (20) ; **caractérisé en ce que** la couche (10) est formée par un matériau à changement de phase présentant un accroissement de volume d'au moins 2% entre une phase cristalline et une phase amorphe et configurée de sorte qu'une modification locale de la phase du matériau à changement de phase forme un motif (40) à la surface de ladite couche (10) ; et **en ce que** le moule (100, 102, 104, 106) comprend des motifs (40) formés par la couche (10) en matériau à changement de phase, la phase du matériau à changement de phase au niveau des motifs (40) étant différente de la phase du matériau à changement de phase au niveau des portions de la couche (10) du matériau à changement de phase qui ne forment pas de motifs (40).

15. Moule (102, 104, 106) selon la revendication précédente dans lequel la couche (10) de matériau à changement de phase présente une première face tournée au regard du support (20) et deuxième face qui est opposée à la première face et qui est recouverte par une couche de protection et dans lequel la couche de protection est de préférence une couche (12) en un matériau diélectrique.

16. Moule (104, 106) selon l'une quelconque des deux revendications précédentes comprenant une couche de régulation thermique disposée entre la couche (10) du matériau à changement de phase et le support (20) et dans lequel la couche de régulation thermique est de préférence une couche (14) en un matériau diélectrique.

17. Moule (106) selon l'une quelconque des trois revendications précédentes comprenant une couche métallique (16) disposée entre la couche (10) du matériau à changement de phase et le support (20).

18. Moule (100, 102, 104, 106) selon l'une quelconque des quatre revendications précédentes présentant une transparence au moins supérieure à 40%.

19. Procédé de modification d'un moule (100) selon l'une quelconque des cinq revendications précédentes, le moule comprenant des motifs (40) en relief formés dans la couche (10) de matériau à changement de phase, le procédé comprenant une étape de modification locale de la phase du matériau à changement de phase de sorte à faire disparaître au moins partiellement un motif (40) existant ou de sorte à étendre un motif (40) existant ou de sorte à former un nouveau motif (40) à la surface de ladite couche (10) de matériau à changement de phase.
